# EUROPÄISCHE PATENTANMELDUNG

(11) **EP 3 822 477 A1**
(43) Veröffentlichungstag der Anmeldung: **19.05.2021**
(21) Anmeldenummer: 20205338.5
(22) Anmeldetag: 03.11.2020
(51) Int. Cl.: F02N 11/08, F02N 15/06, G01R 31/392, F02N 15/02, F02N 15/04

(54) **VERFAHREN ZUM BESTIMMEN EINES LADEZUSTANDS EINER FAHRZEUGBATTERIE EINES FAHRZEUGS**

(30) Priorität: 12.11.2019 DE 102019130431
(71) Anmelder: SEG Automotive Germany GmbH, 70499 Stuttgart (DE)
(72) Erfinder: STÖCKLEIN, Henning, 71735 Eberdingen (DE); KUBELKA, Kevin, 71229 Leonberg-Silberberg (DE); MÜLLER, Jens, 74321 Bietigheim-Bissingen (DE); QIAN, Peng, 70180 Stuttgart (DE); CWIK, Matthias, 70180 Stuttgart (DE); SAADAT, Nima, 70499 Stuttgart (DE)
(74) Vertreter: Steinbauer, Florian

(57) **Zusammenfassung**

Die vorliegende Erfindung betrifft ein Verfahren zum Bestimmen eines Ladezustands einer Fahrzeugbatterie (150) eines Fahrzeugs, wobei ein Starterrelais einer Startvorrichtung (100) für eine Brennkraftmaschine des Fahrzeugs zum Einspuren eines Starterritzels in einen Zahnkranz der Brennkraftmaschine eine erste Wicklung (121) und eine zweite Wicklung (122) aufweist, die unabhängig voneinander ansteuerbar sind, wobei die erste Wicklung (121) in vorbestimmten Ansteuerzuständen angesteuert wird und sich im Zuge dieser Ansteuerzustände einstellende Spannungswerte bestimmt werden und wobei in Abhängigkeit von den bestimmten Spannungswerten der Ladezustand der Fahrzeugbatterie (150) bestimmt wird.

## Beschreibung

Die vorliegende Erfindung betrifft ein Verfahren zum Bestimmen eines Ladezustands einer Fahrzeugbatterie eines Fahrzeugs.

### Stand der Technik

Batterien in Kraftfahrzeugen können zur Versorgung elektrischer Verbraucher in einem Bordnetz sowie zum Starten einer Brennkraftmaschine des Fahrzeugs mit Hilfe einer entsprechenden Startvorrichtung verwendet werden. Dabei kann es von Bedeutung sein, den aktuellen Ladezustand der Batterie zu kennen.

Im Zuge eines sog. Start-Stopp-Betriebs kann die Brennkraftmaschine während des laufenden Betriebs des Fahrzeugs deaktiviert werden, beispielsweise an einer roten Ampel oder im Zuge eines Segelbetriebs, und bei Bedarf wieder gestartet werden. Um dabei ein effektives Wiederstarten der Brennkraftmaschine zu ermöglichen, kann es speziell hier von Bedeutung sein, den aktuellen Ladezustand der Fahrzeugbatterie zu kennen.

### Offenbarung der Erfindung

Vor diesem Hintergrund werden erfindungsgemäß ein Verfahren zum Bestimmen eines Ladezustands einer Fahrzeugbatterie eines Fahrzeugs sowie eine Recheneinheit und ein Computerprogramm zu dessen Durchführung mit den Merkmalen der unabhängigen Patentansprüche vorgeschlagen. Vorteilhafte Ausgestaltungen sind Gegenstand der Unteransprüche sowie der nachfolgenden Beschreibung.

Ein Starterrelais einer Startvorrichtung für eine Brennkraftmaschine des Fahrzeugs ist zum Einspuren eines Starterritzels in einen Zahnkranz der Brennkraftmaschine vorgesehen. Das Starterrelais weist eine erste Wicklung und eine zweite Wicklung auf, die unabhängig voneinander ansteuerbar bzw. unabhängig voneinander bestrombar sind. Im Rahmen des vorliegenden Verfahrens wird die erste Wicklung in vorbestimmten Ansteuerzuständen angesteuert bzw. bestromt und sich im Zuge dieser Ansteuerzustände einstellende Spannungswerte werden bestimmt. In Abhängigkeit von diesen bestimmten Spannungswerten wird der Ladezustand der Fahrzeugbatterie bestimmt. Zweckmäßigerweise wird zur Bestimmung des Ladezustands also nur die erste Wicklung bestromt, die zweite Wicklung bleibt dabei deaktiviert und wird nicht bestromt. Dies hat den Vorteil, dass das Starterrelais dabei nicht betätigt wird und somit das Verfahren jederzeit durchführbar ist.

Das elektromagnetische bzw. elektromechanische Starterrelais ist insbesondere auch zum Schließen eines Stromkreises zwischen dem elektrischen Startermotor und der Fahrzeugbatterie vorgesehen. Jedoch kann für das Schließen des Motorstromkreises auch ein separates Schaltrelais vorhanden sein. Durch Bestromen der ersten und zweiten Wicklung kann insbesondere ein Hubanker in Bewegung versetzt werden, der über einen Einrückhebel mit dem Starterritzel gekoppelt ist. Soweit das Starterrelais Einzugs- und Schaltfunktion vereint, kann insbesondere auch eine Kontaktplatte gegen zwei Gegenkontakte gedrückt werden, um so den Stromkreis des Startermotors zu schließen. Die erste und zweite Wicklung können zweckmäßigerweise als Einzugs- bzw. Haltewicklungen vorgesehen sein, wobei insbesondere zum Betätigen des Starterrelais (d.h. Einziehen des Ankers) sowohl Einzugs- als auch Haltewicklung bestromt werden, zum Halten des Ankers im betätigten Zustand jedoch das Ansteuern nur der Haltewicklung ausreicht.

Insbesondere kann zusätzlich ein elektronisches Vorsteuerrelais zum Ansteuern des Starterrelais und somit der ersten und zweiten Wicklung vorgesehen sein. Beispielsweise kann dieses Vorsteuerrelais eine Recheneinheit wie etwa einen Mikrocontroller und von diesem ansteuerbare Schaltelemente, insbesondere Halbleiterschalter umfassen. Ferner kann das Vorsteuerrelais zweckmäßigerweise mit einem Steuergerät des Fahrzeugs in datenübertragender Verbindung stehen. Zweckmäßigerweise ist ein erstes Schaltelement zum Ansteuern bzw. Bestromen der ersten Wicklung vorgesehen und ein zweites Schaltelement zum Ansteuern der zweiten Wicklung. Durch diese Schaltelemente kann insbesondere eine unabhängige Ansteuerung und Bestromung der Wicklungen ermöglicht werden.

Da die beiden Wicklungen unabhängig voneinander ansteuerbar sind, ergibt sich die Möglichkeit, auch unabhängig von einem Startvorgang der Brennkraftmaschine nur eine der beiden Wicklungen kurzzeitig zu bestromen, ohne die Gefahr einer Beschädigung entsprechender Schaltelemente. Bei einer derartigen kurzzeitigen Bestromung von nur einer Wicklung kann insbesondere bereits ein auswertbarer Spannungseinbruch hervorgerufen werden. Das vorliegende Verfahren schlägt ein Konzept vor, um die erste Wicklung unabhängig von der zweiten Wicklung im Zuge der vorbestimmten Ansteuerzustände derart anzusteuern, dass aus den sich einstellenden Spannungswerten präzise auf den aktuellen Ladezustand der Fahrzeugbatterie rückgeschlossen werden kann.

Die Bestromung der ersten Wicklung kann insbesondere unabhängig von einem Startvorgang der Brennkraftmaschine durchgeführt werden, so dass die Bestimmung des Ladezustands im Zuge des Verfahrens zweckmäßigerweise auch während eines regulären Betriebs oder auch während eines Stillstands des Fahrzeugs bzw. der Brennkraftmaschine ermöglicht wird.

Alternativ kann zum Bestimmen eines Ladezustands einer Fahrzeugbatterie ein Spannungsverlauf an der Batterie während eines Startvorgangs der jeweiligen Brennkraftmaschine erfasst und zusammen mit weiteren Messgrößen ausgewertet werden, z.B. von einem Batterie-Management-System. Zusätzlich kann zu diesem Zweck eine Temperatur der Fahrzeugbatterie erfasst werden, z.B. einer Batterie-Säuretemperatur bei einem Blei-Säure-Akkumulator. Eine derartige Bestimmung des Batteriezustands kann dabei jedoch nur bei einem Einschaltvorgang des entsprechenden Starters durchgeführt werden, so dass der Ladezustand zumeist nur rückblickend auf den zuletzt durchgeführten Startvorgang bestimmt werden kann. Eine Bestimmung des Ladezustands unabhängig von einem Startvorgang ist dabei nicht möglich.

Durch die vorliegende Erfindung wird nun eine Möglichkeit bereitgestellt, den Ladezustand der Fahrzeugbatterie unabhängig von Startvorgängen zu beliebigen Zeitpunkten bestimmen zu können, zweckmäßigerweise auch während des laufenden Betriebs des Fahrzeugs. Insbesondere werden im Laufe des Verfahrens Spannungswerte bestimmt, welche ohnehin zur Regelung bzw. Steuerung der Startvorrichtung erfasst werden, so dass es zweckmäßigerweise keines zusätzlichen Messaufwands bedarf. Ferner ist insbesondere keine Temperaturmessung nötig, insbesondere keine Messung der Batterietemperatur, so dass ein entsprechender Temperatursensor entfallen kann.

Die Bestimmung des Ladezustands kann insbesondere von dem Vorsteuerrelais durchgeführt werden, insbesondere von dem Mikrocontroller dieses Vorsteuerrelais. Insbesondere kann daher auch ein Batterie-Management-System zum Bestimmen des Ladezustands entfallen. Das Vorsteuerrelais kann in diesem Fall beispielsweise weitere die Fahrzeugbatterie betreffende Funktionen ausführen, etwa die Implementierung eines Batteriemodells oder Abschätzung der Batterie-Säuretemperatur.

Insbesondere besteht die erste Wicklung aus einer Legierung mit geringem Temperaturkoeffizienten des elektrischen Widerstands. Der Widerstand der Wicklung ist daher zweckmäßigerweise nahezu unabhängig von der Bauteiltemperatur. Somit kann eine präzise Spannungsmessung während einer Bestromung der Wicklung sowie ferner eine präzise Berechnung des Innenwiderstands des Bordnetzes ermöglicht werden.

Die vorliegende Erfindung ermöglicht es zweckmäßigerweise, den Ladezustand der Fahrzeugbatterie während des laufenden Betriebs des Fahrzeugs bei deaktivierter Brennkraftmaschine präzise bestimmen zu können, etwa im Zuge eines Start-Stopp-Betriebs. Bei Fahrzeugen mit einem derartigen Start-Stopp-Betrieb kann es von besonderer Bedeutung sein, den Zustand der Fahrzeugbatterie möglichst genau zu bestimmen, etwa um eine präzise Prognose des Spannungsverlaufs beim bevorstehenden Widerstart der Brennkraftmaschine zu ermöglichen. Ferner kann das Bordnetz bei häufiger Deaktivierung der Brennkraftmaschine im Zuge des Start-Stopp-Betriebs starken Schwankungen des Ladezustands ausgesetzt sein. Auch bei längerer Dauer der Deaktivierung der Brennkraftmaschine kann es zu Schwankungen des Bordnetzzustands kommen, so dass eine Bestimmung des Batterieladezustands auch bei deaktivierter Brennkraftmaschine von Vorteil ist. Das vorliegende Verfahren bietet sich daher besonders für Fahrzeuge mit einem Start-Stopp-Betrieb an.

Vorzugsweise wird die erste Wicklung im Zuge eines ersten Ansteuerzustands nicht bestromt. Im Zuge eines zweiten und dritten Ansteuerzustands wird die erste Wicklung bevorzugt jeweils auf unterschiedliche Weisen bestromt. Im Zuge des ersten Ansteuerzustands kann zweckmäßigerweise eine Leerlaufspannung bestimmt werden. Im Zuge des zweiten und dritten Ansteuerzustands kann das Bordnetz insbesondere mit zwei verschiedenen Lastpunkten belastet werden, wodurch der Batterieladezustand zweckmäßigerweise präziser ermittelt werden kann als durch Messung der Leerlaufspannung und eines einzelnen Lastpunkts. Dies berücksichtigt beispielsweise die Ermittlung der sog. "extrapolierten Ruhespannung" von Blei-Säure-Akkumulatoren, die für den Ladezustand relevant ist. Ohne bzw. bei sehr geringer Stromlast weisen derartige Fahrzeugbatterien eine höhere Leerlaufspannung auf.

Gemäß einer besonders vorteilhaften Ausführungsform wird die erste Wicklung im Zuge des ersten Ansteuerzustands nicht bestromt und ein erster Spannungswert wird bestimmt. Insbesondere wird der aktuelle Wert der Bordnetzspannung (Batteriespannung) als dieser erste Spannungswert bestimmt. Zweckmäßigerweise kann der erste Spannungswert zwischen Klemme 30 (Leistungsversorgung +) und Klemme 31 (Leistungsversorgung -, Masse) bestimmt werden, beispielsweise mittels eines Analog-Digital-Wandlers des Vorsteuerrelais. Diese Leerlaufspannung bzw. der erste Spannungswert wird im Folgenden auch als U_{30.0} bezeichnet.

Daraufhin wird die erste Wicklung im Zuge des zweiten Ansteuerzustands vorteilhafterweise mit einem ersten Stromniveau bestromt und ein zweiter Spannungswert wird bestimmt. Zweckmäßigerweise wird der zweite Spannungswert bestimmt, nachdem ein Strom durch die erste Wicklung eingeschwungen ist. Insbesondere wird der aktuelle Wert der Bordnetzspannung als zweiter Spannungswert bestimmt, zweckmäßigerweise zwischen den Klemmen 30 und 31. Der zweite Spannungswert wird im Folgenden auch als U_{30.A} bezeichnet.

Anschließend wird die erste Wicklung im Zuge des dritten Ansteuerzustands vorteilhafterweise mit einem zweiten Stromniveau bestromt und ein dritter Spannungswert und ein vierter Spannungswert werden bestimmt. Auch der dritte und vierte Spannungswert werden zweckmäßigerweise bestimmt, nachdem ein Strom durch die erste Wicklung eingeschwungen ist. Als dritter Spannungswert wird zweckmäßigerweise ebenfalls ein aktueller Wert der Bordnetzspannung bestimmt, insbesondere zwischen den Klemmen 30 und 31. Als vierter Spannungswert wird insbesondere ein aktueller Wert der an der ersten Wicklung anliegenden bzw. abfallenden Spannung bestimmt, zweckmäßigerweise zwischen einem Plus-Anschluss der ersten Wicklung und Klemme 31, z.B. zwischen Klemme 50 und 31. Der dritte Spannungswert wird im Folgenden als U_{30.B} bezeichnet, der vierte Spannungswert als U_{EW}. Nach erfolgter Bestimmung des dritten und vierten Spannungswerts kann die Bestromung der ersten Wicklung beendet werden. In Abhängigkeit von dem ersten Spannungswert U_{30.0}, dem zweiten Spannungswert U_{30.A}, dem dritten Spannungswert U_{30.B} und dem vierten Spannungswert U_{EW} wird vorteilhafterweise der Ladezustand der Fahrzeugbatterie bestimmt.

Besonders vorteilhaft wird in Abhängigkeit von dem zweiten Spannungswert U_{30.A}, dem dritten Spannungswert U_{30.B} und dem vierten Spannungswert U_{EW} ein Widerstandswert insbesondere des Innenwiderstands des Bordnetzes (Fahrzeugbatterie sowie Zuleitungen zwischen der Fahrzeugbatterie und der Startvorrichtung) bestimmt. In Abhängigkeit von dem ersten Spannungswert U_{30.0} und von dem Widerstandswert wird vorteilhafterweise der Ladezustand der Fahrzeugbatterie bestimmt. Im Folgenden wird der Widerstandswert insbesondere als R_{ges} bezeichnet.

Der Widerstandswerts R_{ges} wird in Abhängigkeit von dem zweiten Spannungswert U_{30.A}, von dem dritten Spannungswert U_{30.B}, von dem vierten Spannungswert U_{EW} sowie ferner von dem Innenwiderstand R_{EW} der ersten Wicklung bestimmt.

Insbesondere kann der Widerstandswert von dem Mikrocontroller des Vorsteuerrelais bestimmt werden. Ferner kann von dem Mikrocontroller eine Plausibilitätsüberprüfung durchgeführt werden und die Ergebnisse für die Leerlaufspannung U_{30.0} und den Widerstandswert R_{ges} können über eine Kommunikationsschnittstelle, z.B. CAN, an ein Steuergerät des Fahrzeugs übermittelt werden.

Vorzugsweise werden die unterschiedlichen Stromniveaus durch unterschiedliche Tastverhältnisse der Batteriespannung an der ersten Wicklung erzeugt. Beispielsweise wäre es ebenso möglich, die unterschiedlichen Stromniveaus durch unterschiedliches Ansteuern der Schaltelemente im Vorsteuerrelais bereitzustellen. Vorzugsweise wird die erste Wicklung im Zuge des zweiten Ansteuerzustands hochfrequent getaktet bestromt und im Zuge des dritten Ansteuerzustands ungetaktet. Beispielsweise kann für den zweiten Ansteuerzustand ein Tastverhältnis von 50:50 gewählt werden und für den dritten Ansteuerzustand ein Tastverhältnis von 100%. Während des zweiten Ansteuerzustands bricht die Bordnetzspannung dabei zweckmäßigerweise von der Leerlaufspannung U_{30.0} auf den geringeren zweiten Spannungswert U_{30.A} ein. Während des dritten Ansteuerzustands bricht die Bordnetzspannung zweckmäßigerweise von dem zweiten Spannungswert U_{30.A} weiter auf den geringeren dritten Spannungswert U_{30.B} ein.

Bevorzugt wird die erste Wicklung im Zuge des zweiten Ansteuerzustands und des dritten Ansteuerzustands derart bestromt, dass sich im Zuge des zweiten Ansteuerzustands ein Strom durch die erste Wicklung einstellt, dessen Stromstärke geringer ist als im Zuge des dritten Ansteuerzustands. Beispielsweise können der Laststrom bzw. die Stromstärke durch die erste Wicklung im Zuge des zweiten Ansteuerzustands etwa halb so groß sein wie im Zuge des dritten Ansteuerzustands.

Vorzugsweise wird der Ladezustand der Fahrzeugbatterie ferner in Abhängigkeit von einem vorbestimmten Kalibrierwert bestimmt, der einen Zuleitungswiderstand charakterisiert. Als dieser Zuleitungswiderstand sei insbesondere ein Widerstandswert von Zuleitungen zwischen der Fahrzeugbatterie und der Startvorrichtung zu verstehen. Insbesondere wird der bestimmte Widerstandswert R_{ges} zu diesem Zweck um den von dem Zuleitungswiderstand abhängigen Kalibrierwert korrigiert. Der Zuleitungswiderstand zwischen Fahrzeugbatterie und Startvorrichtung, insbesondere der plus- und minusseitigen Starterzuleitung, wird implizit im Rahmen des vorliegenden Verfahrens miterfasst. Um eine noch präzisere und insbesondere fahrzeugspezifische Bestimmung des Ladezustands zu ermöglichen, kann der Zuleitungswiderstand als Kalibrierwert bestimmt und von dem bestimmten Gesamtwiderstand R_{ges} abgezogen werden. Zur Temperaturkompensation des Leitungswiderstands kann das Vorsteuerrelais ferner zweckmäßigerweise die Umgebungstemperatur aus dem Bordnetz erhalten und berücksichtigen, z.B. mittels eines CAN-Parameter der Temperatur der Ansaugluft-Temperatur. Beispielsweise kann der Kalibrierwert im Zuge einer Fahrzeuginbetriebnahme und/oder in regelmäßigen Serviceintervallen unter definierten Bordnetzbedingungen bestimmt werden. Zweckmäßigerweise kann der Kalibrierwert in einem nicht flüchtigen Speicher des Vorsteuerrelais hinterlegt werden, insbesondere innerhalb des Mikrocontrollers.

Bevorzugt wird zunächst eine Zulässigkeitsprüfung durchgeführt und bei positiv durchgeführter Zulässigkeitsprüfung wird vorzugsweise die erste Wicklung in den vorbestimmten Ansteuerzuständen angesteuert und der Ladezustand der Fahrzeugbatterie wird in Abhängigkeit von den bestimmten Spannungswerten bestimmt. Beispielsweise kann das Vorsteuerrelais über eine bidirektionale Kommunikationsschnittstelle, z.B. CAN, eine fahrzeugseitige Anforderung zum Bestimmen des Ladezustands z.B. von einem Steuergerät des Fahrzeugs erhalten. Nach Erkennen dieser Anforderung werden zweckmäßigerweise ein Plausibilitätscheck sowie die Zulässigkeitsprüfung für die Zustandsbestimmung im aktuellen Status des Fahrzeugs durchgeführt. Beispielsweise kann die Anforderung während eines Startvorgangs, eines Auslaufens des Startermotors oder eines Fehlerzustands bezüglich einer Übertemperatur als unzulässig bewertet werden.

Vorteilhafterweise ist die erste Wicklung eine Einzugswicklung und die zweite Wicklung eine Haltewicklung. Die Einzugswicklung ist über das Vorsteuerrelais zweckmäßigerweise mit dem positiven Versorgungsanschluss der Batterie verbunden und ferner insbesondere mit dem Startermotor, insbesondere mit einer Erregerwicklung des Startermotors. Zweckmäßigerweise wird somit zum Bestimmen des Batterieladezustands im Rahmen des vorliegenden Verfahrens nur die Einzugswicklung bestromt, während die Haltewicklung insbesondere unbestromt bleibt.

Gemäß einer besonders vorteilhaften Ausführungsform ist ein erstes Schaltelement zum Ansteuern der ersten Wicklung vorgesehen und ein zweites Schaltelement zum Ansteuern der zweiten Wicklung. Durch diese Schaltelemente kann insbesondere die unabhängige Ansteuerung und Bestromung der ersten und zweiten Wicklung ermöglicht werden. Das erste und das zweite Schaltelement sind insbesondere in dem Vorsteuerrelais zum Ansteuern des Starterrelais angeordnet. Insbesondere können diese Schaltelemente durch den Mikrocontroller des Vorsteuerrelais geschlossen bzw. geöffnet werden, wodurch zweckmäßigerweise die erste und zweite Wicklung angesteuert werden können.

Vorteilhafterweise sind das erste Schaltelement und das zweite Schaltelement jeweils als eine Endstufe ausgebildet, vorzugsweise jeweils als eine HalbleiterEndstufe bzw. Halbleiterschalter. Bevorzugt sind die Schaltelemente jeweils als ein MOSFET ausgebildet. Die Auslegung der Endstufen erlaubt insbesondere eine kurze Einschaltdauer der geschalteten Last, was zweckmäßigerweise sowohl eine getaktete Ansteuerung (zur Strombegrenzung) als auch eine insbesondere wenige Millisekunden andauernde Bestromung der Wicklung ohne Schädigung der Schaltelemente ermöglicht.

Eine erfindungsgemäße Recheneinheit, z.B. ein Steuergerät eines Kraftfahrzeugs, ist, insbesondere programmtechnisch, dazu eingerichtet, ein erfindungsgemäßes Verfahren durchzuführen.

Auch die Implementierung eines erfindungsgemäßen Verfahrens in Form eines Computerprogramms oder Computerprogrammprodukts mit Programmcode zur Durchführung aller Verfahrensschritte ist vorteilhaft, da dies besonders geringe Kosten verursacht, insbesondere wenn ein ausführendes Steuergerät noch für weitere Aufgaben genutzt wird und daher ohnehin vorhanden ist. Geeignete Datenträger zur Bereitstellung des Computerprogramms sind insbesondere magnetische, optische und elektrische Speicher, wie z.B. Festplatten, Flash-Speicher, EEPROMs, DVDs u.a.m. Auch ein Download eines Programms über Computernetze (Internet, Intranet usw.) ist möglich.

Weitere Vorteile und Ausgestaltungen der Erfindung ergeben sich aus der Beschreibung und der beiliegenden Zeichnung.

Die Erfindung ist anhand von Ausführungsbeispielen in der Zeichnung schematisch dargestellt und wird im Folgenden unter Bezugnahme auf die Zeichnung beschrieben.

Kurze Beschreibung der Zeichnungen
- Figur 1: zeigt schematisch eine Startvorrichtung für eine Brennkraftmaschine eines Fahrzeugs, welche dazu eingerichtet ist, eine bevorzugte Ausführungsform des erfindungsgemäßen Verfahrens durchzuführen.
- Figur 2: zeigt schaltplanartig einen Teil einer Startvorrichtung für eine Brennkraftmaschine eines Fahrzeugs, welche dazu eingerichtet ist, eine bevorzugte Ausführungsform des erfindungsgemäßen Verfahrens durchzuführen.
- Figur 3: zeigt schematisch eine bevorzugte Ausführungsform des erfindungsgemäßen Verfahrens als ein Blockdiagramm.
- Figur 4: zeigt schematisch ein Spannungs-Zeit-Diagramm, das im Zuge einer bevorzugten Ausführungsform des erfindungsgemäßen Verfahrens erfasst werden kann.

### Ausführungsform(en) der Erfindung

In den Figuren bezeichnen gleiche Bezugszeichen gleiche oder baugleiche Elemente.

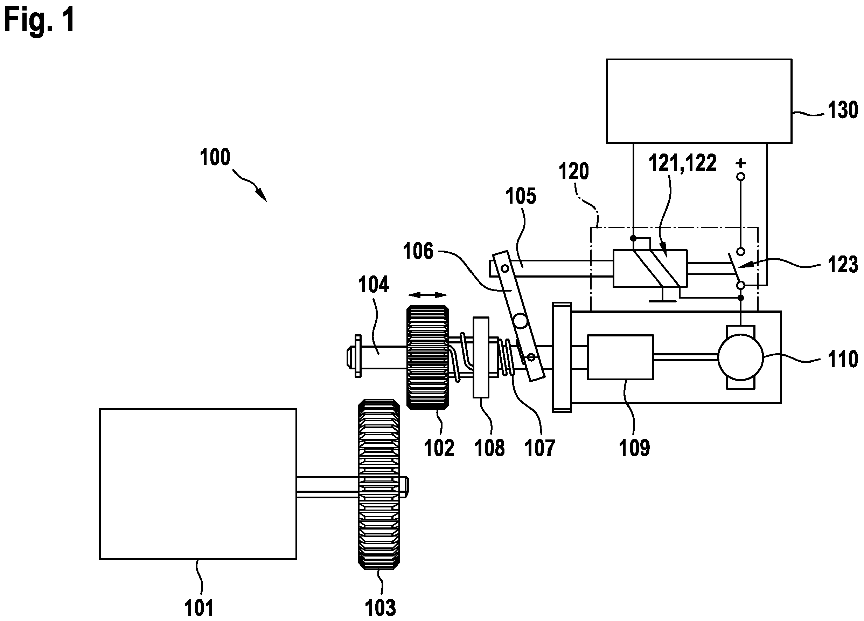

In Figur 1 ist eine Startvorrichtung 100 für eine Brennkraftmaschine 101 eines Fahrzeugs schematisch dargestellt.

Die Startvorrichtung 100 weist ein Starterritzel 102 auf, das zum Starten der Brennkraftmaschine 101 in Eingriff mit einem Zahnkranz 103 der Brennkraftmaschine gebracht wird. Das Starterritzel 102 ist auf einer Welle 104 wie mit dem Doppelpfeil gekennzeichnet axial verschieblich gelagert, wobei das Starterritzel 102 drehfest mit der Welle 104 gekoppelt ist. Das Starterritzel 102 wird zwischen einer zurückgezogenen Außerfunktionsposition und einer vorgerückten Eingriffsposition mit dem Zahnkranz 103 der Brennkraftmaschine 101 über ein Starterrelais 120 verstellt, das elektromagnetisch ausgebildet ist und zwei Wicklungen 121, 122 sowie einen Hubanker 105 umfasst, der bei Bestromung der Wicklungen 121, 122 in diese axial hineingezogen wird. Der Hubanker 105 betätigt einen Einrückhebel 106, der eine Einspurfeder 107 beaufschlagt, die auf einem Mitnehmer 108 eines Rollenfreilaufs aufsitzt. Das Starterritzel 102 ist abtriebsseitig mit dem Mitnehmer 108 gekoppelt, so dass die axiale Vorschubbewegung des Mitnehmers 108 in die gewünschte axiale Stellbewegung des Starterritzels 102 zwischen der Außerfunktionsposition und der Eingriffsposition umgesetzt wird.

Die drehende Antriebsbewegung auf die Welle 104 bzw. das Starterritzel 102 wird mithilfe eines elektrischen Startermotors 110 erzeugt, der über ein Getriebe 109, beispielsweise ein Planetengetriebe mit der Welle 104 gekoppelt ist. Bei einer Betätigung des elektrischen Startermotors 110 wird die Welle 104 und damit auch das Starterritzel 102 in Drehung versetzt.

Das Einschalten des Startermotors 110 erfolgt über eine Einschalteinrichtung 123, die in das Starterrelais 120 integriert ist. Der Stromkreis wird in der Einschalteinrichtung 123 mittels eines Schaltglieds geschlossen, das als Schaltanker ausgeführt ist und bei Bestromung der Wicklungen 121, 122 verstellt wird. Bei geschlossenem Stromkreis wird der Startermotor 110 in Bewegung gesetzt und die Welle 104 sowie das Starterritzel 102 drehend angetrieben. Ein elektronisches Vorsteuerrelais 130 oder ein Zündschalter (nicht gezeigt) kann zum Ansteuern des Starterrelais 120 sowie des Startermotors 110 vorgesehen sein.

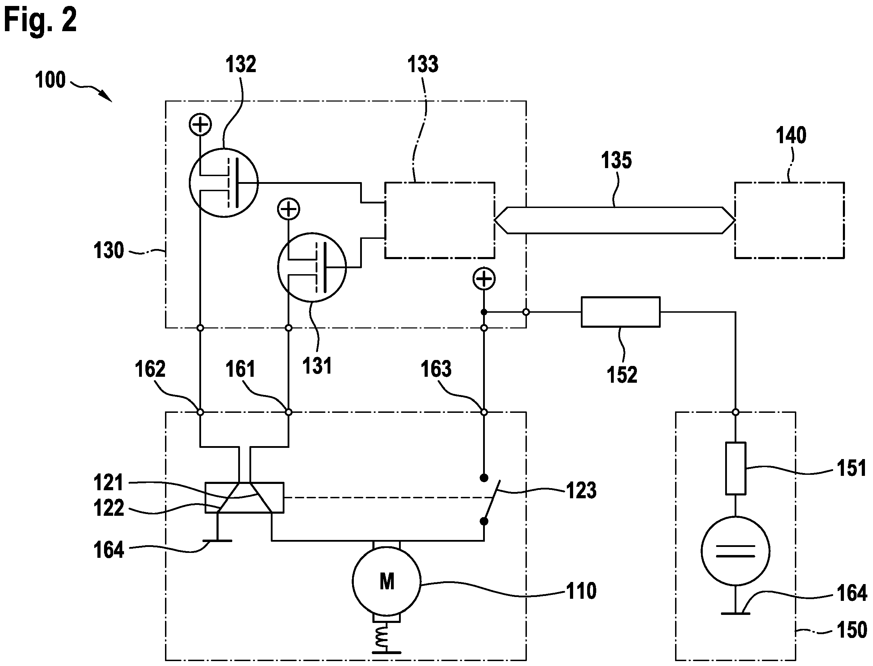

Figur 2 zeigt schaltplanartig einen Teil der Startvorrichtung 100. Wie in Figur 2 dargestellt, umfasst das Vorsteuerrelais 130 ein erstes Schaltelement 131 zum Ansteuern der ersten Wicklung 121 und ein zweites Schaltelement 132 zum Ansteuern der zweiten Wicklung 122.

Die Schaltelemente 131, 132 sind jeweils als eine Halbleiterendstufe ausgebildet, beispielsweise jeweils als ein MOSFET. Ferner umfasst das Vorsteuerrelais 130 eine Recheneinheit 133, die beispielsweise als ein Mikrocontroller ausgebildet ist und über ein Kommunikationssystem 135, z.B. CAN, mit einem Steuergerät 140 des Fahrzeugs in datenübertragender Verbindung steht.

Das erste Schaltelement 131 kann über einen Anschluss 161, z.B. über eine Klemme 50k, mit der ersten Wicklung 121 verbunden sein. Das zweite Schaltelement 132 kann über einen Anschuss 162, z.B. Klemme 50i, mit der zweiten Wicklung 122 verbunden sein.

Die erste Wicklung 121 ist insbesondere als Einzugswicklung ausgebildet und ist dem Startermotor 110 verbunden. Die zweite Wicklung 122 ist insbesondere als Haltewicklung ausgebildet und ferner über einen Anschuss 164, z.B. Klemme 31, mit Masse verbunden.

Über einen Anschluss 163, z.B. Klemme 30, ist die Einschalteinrichtung 123 mit einer Fahrzeugbatterie 150 verbunden. Mit Bezugszeichen 151 ist ein Innenwiderstand der Batterie 150 bezeichnet, mit Bezugszeichen 152 ein Zuleitungswiderstand von Zuleitungen zwischen der Fahrzeugbatterie 150 und der Startvorrichtung 100.

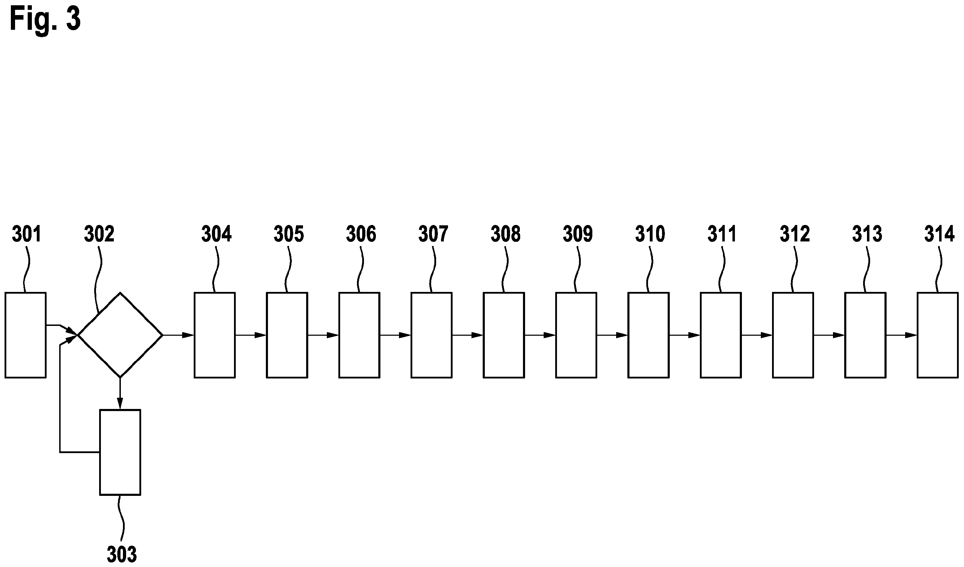

Mit Hilfe der Startvorrichtung 100 kann im Rahmen des vorliegenden Verfahrens ein Ladezustand der Fahrzeugbatterie 150 bestimmt werden. Zu diesem Zweck ist der Mikrocontroller 133, insbesondere programmtechnisch, dazu eingerichtet, eine bevorzugte Ausführungsform eines erfindungsgemäßen Verfahrens durchzuführen, welche in Figur 3 schematisch als ein Blockdiagramm dargestellt ist und nachfolgend erläutert werden soll.

In einem Schritt 301 empfängt der Mikrocontroller 133 über das Kommunikationssystem 135 eine Anforderung zur Ladezustandsbestimmung von dem Steuergerät 140.

In Schritt 302 führt der Mikrocontroller 133 eine Zulässigkeitsprüfung durch, ob die Bestimmung des Ladezustands im aktuellen Status des Fahrzeugs zulässig ist. Wird die Anfrage als nicht zulässig bewertet, etwa während eines Startvorgangs oder eines Auslaufens des Startermotors 110, wird in Schritt 303 für die Dauer eines vorgegebenen Zeitintervalls abgewartet und anschließend erneut überprüft, ob die Anforderung nun zulässig ist.

Bei positiver durchgeführter Zulässigkeitsprüfung wird der Ladezustand der Fahrzeugbatterie 150 bestimmt. Zu diesem Zweck wird in Schritt 304 die erste Wicklung 121 mit Hilfe des ersten Schaltelements 131 in einem ersten Ansteuerzustand angesteuert und dabei insbesondere nicht bestromt. Dabei wird ferner als ein erster Spannungswert U_{30.0} die Leerlaufspannung bzw. die Bordnetzspannung zwischen Klemme 30 (Anschluss 163) und Klemme 31 (z.B. am Gehäuse oder Anschuss 164) bestimmt.

In Schritt 305 wird die erste Wicklung 121 daraufhin mit Hilfe des ersten Schaltelements 131 in einem zweiten Ansteuerzustand hochfrequent getaktet bestromt, mit einem ersten Tastverhältnis von beispielsweise 50:50, so dass sich ein Strom durch die erste Wicklung 121 von ca. 100 A einstellt.

In Schritt 306 wird abgewartet, bis der Strom durch die erste Wicklung 121 eingeschwungen ist.

Daraufhin wird in Schritt 307 als ein zweiter Spannungswert U_{30.A} erneut die Bordnetzspannung zwischen der Klemme 30 (Anschluss 163) und Klemme 31 (Anschuss 164) bestimmt.

Bei einem Gesamtinnenwiderstand eines 24 V-Bordnetzes beispielsweise im Bereich zwischen 5 mΩ und 8 mΩ bei einer voll geladenen, warmen Fahrzeugbatterie, führt eine Belastung mit einem Strom durch die erste Wicklung von 100 A beispielsweise zu einem Spannungseinbruch zwischen 0,5 V und 0,8 V, der zweckmäßigerweise mit ausreichender Auflösung erfassbar ist, z.B. mittels eines Analog-Digital-Wandlers des Vorsteuerrelais.

Anschließend wird die erste Wicklung 121 in Schritt 308 mit Hilfe des ersten Schaltelements 131 in einem dritten Ansteuerzustand ungetaktet bestromt, mit einem zweiten Tastverhältnis von beispielsweise 100%. Insbesondere ergibt sich dabei ein Strom durch die erste Wicklung 121 von ca. 200 A.

In Schritt 309 wird erneut abgewartet, bis der Strom durch die Wicklung 121 eingeschwungen ist.

In Schritt 310 werden daraufhin ein dritter Spannungswert U_{30.B} und ein vierter Spannungswert U_{EW} bestimmt. Als dritter Spannungswert U_{30.B} wird erneut die Bordnetzspannung zwischen Klemme 30 (Anschluss 163) und Klemme 31 (Anschuss 164) bestimmt. Als vierter Spannungswert U_{EW} wird die aktuell an der ersten Wicklung 121 anliegende Spannung bestimmt, z.B. zwischen der Klemme 31 (Anschuss 164) und 50k (Anschluss 161).

In Schritt 311 wird die Bestromung der ersten Wicklung 121 beendet und in Schritt 312 werden die bestimmten Spannungswerte ausgewertet. Im Zuge dessen wird in Abhängigkeit von dem zweiten Spannungswert U_{30.A}, von dem dritten Spannungswert U_{30.B} und von dem vierten Spannungswert U_{EW} ein Innenwiderstand des Bordnetzes als Widerstandswert R_{ges} bestimmt.

Insbesondere gelten für die Bestimmung des Widerstandswerts R_{ges} folgende Beziehungen:

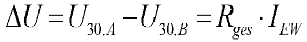

Für den Strom I_{EW} durch die erste Wicklung gilt folgende Beziehung:

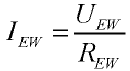

Daraus ergibt sich:

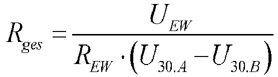

R_{EW} ist der Innenwiderstand der ersten Wicklung 121, der in erster Näherung als konstant angesehen werden kann und beispielsweise 100 mΩ beträgt. Insbesondere ist dieser Innenwiderstand R_{EW} durch Konstruktion und Materialkenndaten bekannt.

Ferner wird der Widerstandswert R_{ges} um einen Kalibrierwert korrigiert, welcher dem Zuleitungswiderstand 152 der Zuleitungen zwischen der Fahrzeugbatterie 150 und Startvorrichtung 100 entspricht. Dieser Kalibrierwert kann beispielsweise im Zuge einer Inbetriebnahme des Fahrzeugs bestimmt werden und in einem nicht flüchtigen Speicher des Mikrocontrollers 133 hinterlegt sein. Insbesondere entspricht der um den Kalibrierwert korrigierte Widerstandswert R_{ges} dem Innenwiderstand 151 der Fahrzeugbatterie 150.

In Schritt 313 werden nun der korrigierte Widerstandswert R_{ges} sowie der erste Spannungswert U_{30.0} von dem Mikrocontroller 133 über das Kommunikationssystem 135 an das Steuergerät 140 als aktueller Ladezustand der Fahrzeugbatterie 150 rückgemeldet. In Schritt 314 beendet der Mikrocontroller 133 die Funktion der Ladezustandsbestimmung.

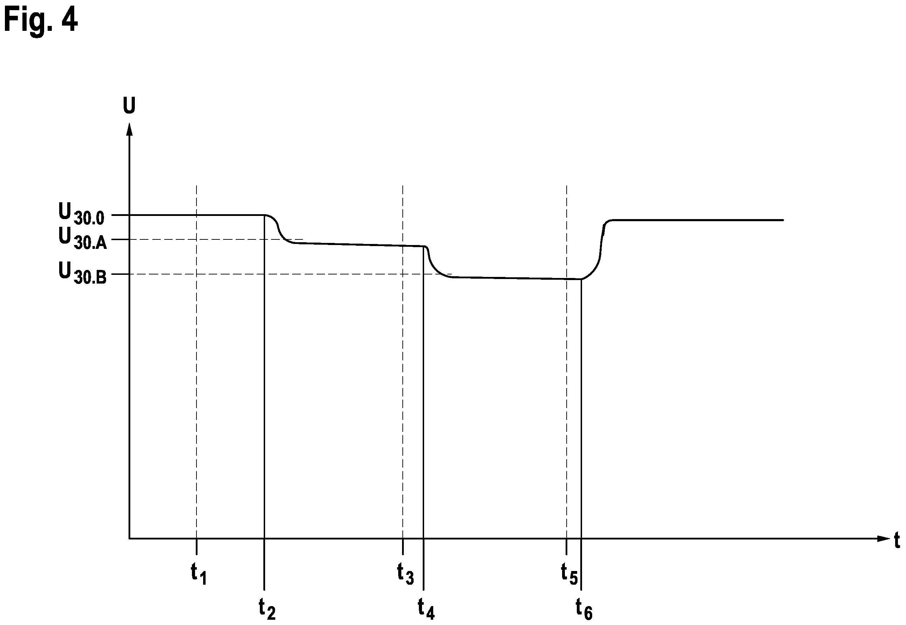

Figur 4 zeigt schematisch ein Spannungs-Zeit-Diagramm, das im Zuge einer bevorzugten Ausführungsform des erfindungsgemäßen Verfahrens erfasst werden kann. Beispielhaft ist in Figur 4 ein zeitlicher Verlauf der Bordnetzspannung U zwischen den Klemmen 30 (Anschluss 163) und 31 (Anschluss 164) aufgetragen gegen die Zeit t dargestellt.

Zu einem Zeitpunkt t₁ wird die erste Wicklung 121 gemäß dem ersten Ansteuerzustand nicht bestromt und der erste Spannungswert U_{30.0} wird gemäß Schritt 304 bestimmt.

Ab Zeitpunkt t₂ wird die Wicklung 121 gemäß Schritt 305 im Zuge des zweiten Ansteuerzustands angesteuert, woraufhin die Bordnetzspannung von dem ersten Spannungswert U_{30.0} auf den zweiten Spannungswert U_{30.A} abfällt. Zu dem Zeitpunkt t₃ wird der zweite Spannungswert U_{30.A} gemäß Schritt 307 bestimmt.

Zu dem Zeitpunkt t₄ wird mit der Bestromung der Wicklung 121 im Zuge des dritten Ansteuerzustands gemäß Schritt 308 begonnen, woraufhin die Bordnetzspannung von dem zweiten auf den dritten Spannungswert U_{30.B} abfällt. Der dritte Spannungswert U_{30.B} wird gemäß Schritt 310 zu dem Zeitpunkt t₅ bestimmt. Zu dem Zeitpunkt t₆ wird die Bestromung der Wicklung 121 beendet.

## Patentansprüche

1. Verfahren zum Bestimmen eines Ladezustands einer Fahrzeugbatterie (150) eines Fahrzeugs,
wobei ein Starterrelais (120) einer Startvorrichtung (100) für eine Brennkraftmaschine (101) des Fahrzeugs zum Einspuren eines Starterritzels (102) in einen Zahnkranz (103) der Brennkraftmaschine (101) eine erste Wicklung (121) und eine zweite Wicklung (122) aufweist, die unabhängig voneinander ansteuerbar sind,
wobei die erste Wicklung (121) in vorbestimmten Ansteuerzuständen angesteuert wird (304, 305, 308) und sich im Zuge dieser Ansteuerzustände einstellende Spannungswerte bestimmt werden (304, 307, 310) und
wobei in Abhängigkeit von den bestimmten Spannungswerten der Ladezustand der Fahrzeugbatterie (150) bestimmt wird (312).

2. Verfahren nach Anspruch 1, wobei die erste Wicklung (121) im Zuge eines ersten Ansteuerzustands nicht bestromt wird (304) und wobei die erste Wicklung (121) im Zuge eines zweiten und dritten Ansteuerzustands jeweils auf unterschiedliche Weisen bestromt wird (305, 308).

3. Verfahren nach Anspruch 2,
wobei die erste Wicklung (121) im Zuge des ersten Ansteuerzustands nicht bestromt wird und ein erster Spannungswert (U_{30.0}) bestimmt wird (304),
wobei die erste Wicklung (121) im Zuge des zweiten Ansteuerzustands mit einem ersten Stromniveau bestromt wird (305) und ein zweiter Spannungswert (U_{30.A}) bestimmt wird (307),
wobei die erste Wicklung (121) im Zuge des dritten Ansteuerzustands mit einem zweiten Stromniveau bestromt wird (308) und wobei ein dritter Spannungswert (U_{30.B}) und ein vierter Spannungswert bestimmt werden (310) und
wobei in Abhängigkeit von dem ersten Spannungswert (U_{30.0}), dem zweiten Spannungswert (U_{30.A}), dem dritten Spannungswert (U_{30.B}) und dem vierten Spannungswert der Ladezustand der Fahrzeugbatterie (150) bestimmt wird (312).

4. Verfahren nach Anspruch 3, wobei in Abhängigkeit von dem zweiten Spannungswert (U_{30.A}), dem dritten Spannungswert (U_{30.B}) und dem vierten Spannungswert ein Widerstandswert bestimmt wird und wobei in Abhängigkeit von dem ersten Spannungswert (U_{30.0}) und von dem Widerstandswert der Ladezustand der Fahrzeugbatterie (150) bestimmt wird (312).

5. Verfahren nach einem der Ansprüche 2 bis 4, wobei unterschiedliche Stromniveaus durch unterschiedliche Tastverhältnisse der Batteriespannung an der Wicklung erzeugt werden.

6. Verfahren nach Anspruch 5, wobei die erste Wicklung (121) im Zuge des zweiten Ansteuerzustands hochfrequent getaktet bestromt wird (305) und im Zuge des dritten Ansteuerzustands ungetaktet bestromt wird (308).

7. Verfahren nach einem der Ansprüche 2 bis 6, wobei die erste Wicklung (121) im Zuge des zweiten Ansteuerzustands und des dritten Ansteuerzustands derart bestromt wird, dass sich im Zuge des zweiten Ansteuerzustands ein Strom durch die erste Wicklung (121) einstellt, dessen Stromstärke geringer ist als im Zuge des dritten Ansteuerzustands (305, 308).

8. Verfahren nach einem der vorstehenden Ansprüche, wobei der Ladezustand der Fahrzeugbatterie (150) ferner in Abhängigkeit von einem vorbestimmten Kalibrierwert bestimmt wird (312), der einen Zuleitungswiderstand (152) charakterisiert.

9. Verfahren nach einem der vorstehenden Ansprüche, wobei zunächst eine Zulässigkeitsprüfung durchgeführt wird (302) und wobei bei positiver durchgeführter Zulässigkeitsprüfung die erste Wicklung (121) in den vorbestimmten Ansteuerzuständen angesteuert wird (304, 305, 308) und der Ladezustand der Fahrzeugbatterie (150) in Abhängigkeit von den bestimmten Spannungswerten bestimmt wird (312).

10. Verfahren nach einem der vorstehenden Ansprüche, wobei die erste Wicklung (121) eine Einzugswicklung und die zweite Wicklung (122) eine Haltewicklung ist.

11. Verfahren nach einem der vorstehenden Ansprüche, wobei ein erstes Schaltelement (131) zum Ansteuern der ersten Wicklung (121) vorgesehen ist und wobei ein zweites Schaltelement (132) zum Ansteuern der zweiten Wicklung (122) vorgesehen ist.

12. Verfahren nach Anspruch 11, wobei das erste Schaltelement (131) und das zweite Schaltelement (132) jeweils als eine Endstufe, insbesondere jeweils als ein Halbleiterschalter, insbesondere jeweils als ein MOSFET ausgebildet sind.

13. Recheneinheit (133), die dazu eingerichtet ist, alle Verfahrensschritte eines Verfahrens nach einem der Ansprüche 1 bis 12 durchzuführen.

14. Computerprogramm, das eine Recheneinheit (133) dazu veranlasst, alle Verfahrensschritte eines Verfahrens nach einem der Ansprüche 1 bis 12 durchzuführen, wenn es auf der Recheneinheit (133) ausgeführt wird.

15. Maschinenlesbares Speichermedium mit einem darauf gespeicherten Computerprogramm nach Anspruch 14.
